# EUROPEAN PATENT SPECIFICATION

(11) **EP 0 414 520 B1**
(45) Date of publication and mention of the grant of the patent: **08.06.1994**
(21) Application number: 90309203.9
(22) Date of filing: 22.08.1990
(51) Int. Cl.: H01L 27/118

(54) **Master slice type semiconductor devices**
Masterslice-Halbleitervorrichtung
Dispositifs semi-conducteurs du type "master slice"

(30) Priority: 25.08.1989 JP 219970/89
(43) Date of publication of application: 27.02.1991
(73) Proprietor: SONY CORPORATION, Tokyo 141 (JP)
(72) Inventor: Otsu, Takaji, c/o Patents Division, Shinagawa-ku Tokyo 141 (JP)
(74) Representative: Cotter, Ivan John

(56) References cited:
- EP-A- 0 131 463
- PATENT ABSTRACTS OF JAPAN, vol. 11, no. 122 (E-500)[2569], 16th April 1987; & JP-A-61 268 040
- PATENT ABSTRACTS OF JAPAN, vol. 8, no. 285 (E-287)[1722], 26th December 1984; & JP-A-59 150 446

## Description

This invention relates to semiconductor devices of the master slice type.

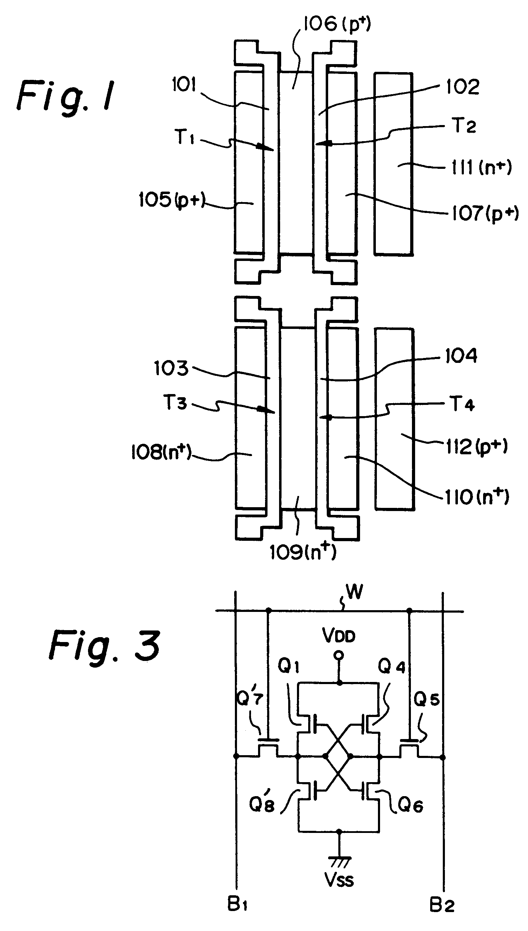

A gate array is one example of a logic device referred to as a semiconductor device of the master slice type (or logic array). A gate array may for example comprise a CMOS (complementary metal oxide semiconductor) gate array. Figure 1 of the accompanying drawings shows an example of a basic cell of a previously proposed CMOS gate array. (The gate array comprises an array of such cells.) As shown in Figure 1, the basic cell of the previously proposed CMOS gate array comprises two p-channel MOS transistors T1 and T2 and two n-channel MOS transistors T3 and T4. The values of ratios W/L (W = channel width, L = channel length) of the transistors T1 and T2 are equal. The values of the ratios W/L of the transistors T3 and T4 are also the same. The transistors T1 to T4 have gate electrodes 101 to 104. p⁺-type semiconductor regions 105 to 107 are used as source regions or drain regions of the p-channel MOS transistors T1 and T2. The semiconductor regions 105 to 107 are formed in, for example, an n-well formed in a semiconductor substrate (not shown). n⁺-type semiconductor regions 108 to 110, for instance, are used as source regions or drain regions of the n-channel MOS transistors T3 and T4. The semiconductor regions 108 to 110 are formed in, for example, a p-well formed in the semiconductor substrate (not shown). In this case, the p-channel MOS transistor T1 is formed by the gate electrode 101 and the semiconductor regions 105 and 106 and the p-channel MOS transistor T2 is formed by the gate electrode 102 and the semiconductor regions 106 and 107. Similarly, the n-channel MOS transistor T3 is formed by the gate electrode 103 and the semiconductor regions 108 and 109 and the n-channel MOS transistor T4 is formed by the gate electrode 104 and the semiconductor regions 109 and 110. An n⁺-type semiconductor region 111 is used as wiring to supply a power source voltage VDD to (make the voltage come into contact with) the n-well, and a p⁺-type semiconductor region 112 is used as wiring to supply a power source voltage VSS to (make the voltage come into contact with) the p-well.

The following problems arise in the case of constructing, for instance, a full CMOS type static random access memory (RAM) using the previously proposed CMOS gate array comprising basic cells as described with reference to Figure 1. Memory cells of a full CMOS type static RAM are ordinarily constructed from four n-channel MOS transistors and two p-channel MOS transistors. Therefore, in the case of constructing memory cells of a full CMOS type static RAM using basic cells as described with reference to Figure 1, two such basic cells are needed for each memory cell. Thus, two p-channel MOS transistors remain unused. That is, in the case of constructing memory cells of a full CMOS type static RAM by using basic cells as described with reference to Figure 1, half of one basic cell is not used, whereby the efficiency of usage of the basic cells is low. Thus, it is difficult to improve the integration density of the memory cells.

Further, in the case of constructing a 2-input NAND circuit, a 2-input NOR circuit, an inverter circuit, a transmission circuit or the like using a basic cell as described with reference to Figure 1, an optimum circuit construction cannot easily be obtained for various reasons, including the fact that the degree of freedom of wiring between the transistors is small.

Patents Abstracts of Japan, vol 11, no. 122 (E-500) [2569], 16.4.87, describes a semiconductor device including an array of cells, each cell comprising four pairs of MOS transistors wherein the transistors of each pair have a common gate electrode for the pair. Patents Abstracts of Japan, vol 8, No. 285 , (E287) [1772], 26.12.84, describes a semiconductor device wherein the transistors of a basic cell have independent gate electrodes.

According to the invention there is provided a semiconductor device of the master slice type, the device having a basic cell comprising:
first and second MOS transistors of a first conductivity type, between which one of a source region and a drain region is commonly used;
third and fourth MOS transistors of the first conductivity type, between which one of a source region and a drain region is commonly used;
fifth and sixth MOS transistors of a second conductivity type, between which one of a source region and a drain region is commonly used; and
seventh and eighth MOS transistors of the second conductivity type, between which one of a source region and a drain region is commonly used;
a gate electrode being commonly used between the first and third MOS transistors, a gate electrode being commonly used between the second and fourth MOS transistors, a gate electrode being commonly used between the fifth and seventh MOS transistors and gate electrodes of the sixth and eighth MOS transistors being separately used from each other.

Preferred embodiments of the invention described hereinbelow enable a high integration density of memory cells to be realised in the case of constructing a full CMOS type static RAM; and enable a circuit construction near or approaching an optimum construction to be realised in the case of constructing a NAND circuit, a NOR circuit, or the like.

According to the preferred embodiments, use is made of a basic cell comprising four MOS transistors of a first conductivity type and four MOS transistors of a second conductivity type. Therefore, a memory cell of a full CMOS type static RAM comprising two p-channel MOS transistors and four n-channel MOS transistors can be constructed from one such basic cell. In this case, although two p-channel MOS transistors in the basic cell remain unused, those two p-channel MOS transistors merely occupy about 1/4 of the basic cell. Therefore, the efficiency of usage of the basic cell is higher than in the case of constructing a memory cell of the full CMOS type static RAM by using the previously proposed basic cell described with reference to Figure 1. Thus, a high integration density of the memory cell can be realised. Further, as compared with the previously proposed basic cell described with reference to Figure 1, the degree of freedom of wiring between the transistors is larger. Therefore, in the case of constructing a HAND circuit, a NOR circuit, or the like, a circuit construction near or approaching an optimum construction can be realised.

The invention will now be further described, by way of illustrative and non-limiting example, with reference to the accompanying drawings, in which:
Figure 1 is a plan view of a basic cell of a previously proposed CMOS gate array;
Figure 2 is a plan view showing an embodiment in which a CMOS gate array embodying the invention is used to construct a full CMOS type static RAM;
Figure 3 is a circuit diagram of an equivalent circuit of a memory cell of the full CMOS type static RAM shown in Figure 2;
Figure 4 is a plan view of a basic cell of the CMOS gate array embodying the invention;
Figure 5 is a plan view showing an embodiment in which the CMOS gate array embodying the invention is used to construct a 2-input NAND circuit;
Figure 6 is a circuit diagram of an equivalent circuit of the 2-input NAND circuit shown in Figure 5;
Figure 7 is a plan view showing an embodiment in which the CMOS gate array embodying the invention is used to construct a 2-input NOR circuit; and
Figure 8 is a circuit diagram of an equivalent circuit of the 2-input NOR circuit shown in Figure 7.

Embodiments of the present invention will now be described with reference to the drawings. All of the following embodiments use a CMOS gate array, embodying the invention, of the sea of gate (whole surface layout) type. Throughout the figures of the drawings, like portions are designated by the same references.

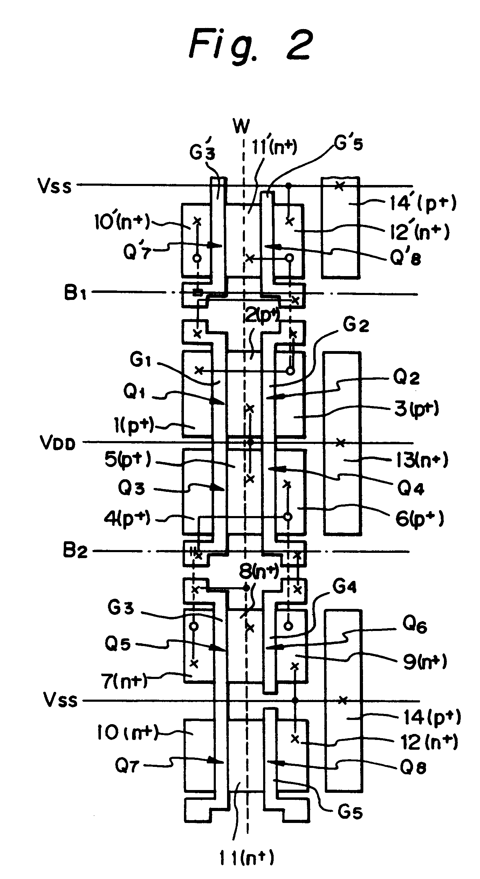

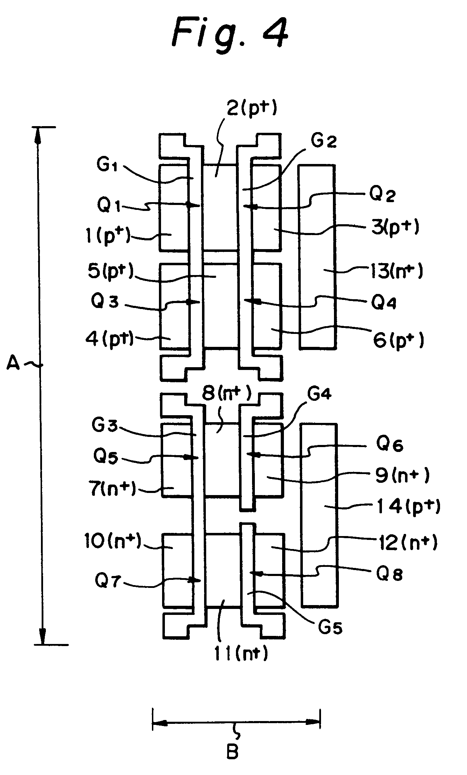

Figure 2 shows an embodiment in which a full CMOS type static RAM is constructed from a CMOS gate array, embodying the invention, of the sea of gate type. Figure 3 shows an equivalent circuit of a memory cell of the full CMOS type static RAM shown in Figure 2. Figure 4 shows a basic cell of the sea of gate type CMOS gate array.

First, the construction of the basic cell of the sea of gate type CMOS gate array will be described. As shown in Figure 4, the basic cell comprises four p-channel MOS transistors Q1 to Q4 and four n-channel MOS transistors Q5 to Q8. The values of the ratios W/L (W = channel width, L = channel length) of the transistors Q1 to Q4 are equal. The values of the ratios W/L of the transistors Q5 to Q8 are also equal. Five gate electrodes G1 to G5 are provided. The gate electrode G1 is commonly used between the p-channel MOS transistors Q1 and Q3. The gate electrode G2 is commonly used between the p-channel MOS transistors Q2 and Q4. The gate electrode G3 is commonly used between the n-channel MOS transistors Q5 and Q7. In contrast, the gate electrodes for the n-channel MOS transistors Q6 and Q8, namely the gate electrodes G4 and G5, are separate from each other. Each of the gate electrodes G1 to G5 can be formed by, for instance, an n⁺-type polycrystalline silicon (Si) film doped with an impurity such as phosphorus (P) or a polycide film in which a refractory metal silicide film such as a tungsten silicide (WSi₂) film has been laid on the n⁺-type polycrystalline Si film.

p⁺-type semiconductor regions 1 to 6, for instance, are used as source regions or drain regions of the p-channel MOS transistors Q1 to Q4. The semiconductor regions 1 to 6 are formed in, for example, an n-well formed in a semiconductor substrate (not shown). n⁺-type semiconductor regions 7 to 12, for instance, are used as source regions or drain regions of the n-channel MOS transistors Q5 to Q8. The semiconductor regions 7 to 12 are formed in, for example, a p-well formed in the semiconductor substrate (not shown). An n⁺-type semiconductor region 13 is used as wiring to supply a power source voltage VDD to (make the voltage come into contact with) the n-well. A p⁺-type semiconductor region 14, for instance, is used as wiring to supply a power source voltage VSS to (make the voltage come into contact with) the p-well.

In this embodiment, the p-channel MOS transistor Q1 is formed by the gate electrode G1 and the semiconductor regions 1 and 2, the p-channel MOS transistor Q2 is formed by the gate electrode G2 and the semiconductor regions 2 and 3, and the semiconductor region 2 is commonly used between the p-channel MOS transistors Q1 and Q2. On the other hand, the p-channel MOS transistor Q3 is formed by the gate electrode G1 and the semiconductor regions 4 and 5, the p-channel MOS transistor Q4 is formed by the gate electrode G2 and the semiconductor regions 5 and 6, and the semiconductor region 5 is commonly used between the p-channel MOS transistors Q3 and Q4. Further, the n-channel MOS transistor Q5 is formed by the gate electrode G3 and the semiconductor regions 7 and 8, the n-channel MOS transistor Q6 is formed by the gate electrode G4 and the semiconductor regions 8 and 9, and the semiconductor region 8 is commonly used between the n-channel MOS transistors Q5 and Q6. Also, the n-channel MOS transistor Q7 is formed by the gate electrode G3 and the semiconductor regions 10 and 11, the n-channel MOS transistor Q8 is formed by the gate electrode G5 and the semiconductor regions 11 and 12, and the semiconductor region 11 is commonly used between the p-channel MOS transistors Q7 and Q8.

An example of the dimensions of the basic cell shown in Figure 4 is as follows. For instance, when a design rule is set to 0.7 micrometres, assuming that a length of one unit on the design is set to 1G (grid), dimensions A and B (shown in Figure 4) of the basic cell can be set to 14G and 3.5G, respectively. For instance, assuming that 1G = 2.1 micrometres, A = 14 x 2.1 = 29.4 micrometres and B = 3.5 x 2.1 = 7.35 micrometres. The ratio W/L of the p-channel MOS transistors Q1 to Q4 equals 4.9 micrometres/0.8 micrometres. The ratio W/L of the n-channel MOS transistors Q5 to Q8 equals 4.2 micrometres/0.7 micrometres. The values of the ratios W/L of the p-channel MOS transistors Q1 to Q4 and the n-channel MOS transistors Q5 to Q8 are almost equal. In this case, the performance ratio of the p-channel MOS transistors Q1 to Q4 to the n-channel MOS transistors Q5 to Q8 is proportional to the ratio of the hole mobility to the electron mobility.

A description will now be given of the embodiment in which a full CMOS type static RAM is constructed from the sea of gate type CMOS gate array comprising basic cells as described with reference to Figure 4.

As shown in Figures 2 and 3, a flip-flop circuit of a memory cell of the full CMOS type static RAM is constructed from p-channel MOS transistors Q1 and Q4 and n-channel MOS transistors Q8′ and Q6. The n-channel MOS transistor Q8′ corresponds to the n-channel MOS transistor Q8 of the MOS transistors making up a basic cell adjacent to a basic cell comprising the p-channel MOS transistors Q1 to Q4 and the n-channel MOS transistors Q5 to Q8. One of two CMOS inverters of the flip-flop circuit is constituted by the p-channel MOS transistor Q1 and the n-channel MOS transistor Q8′. The other CMOS inverter is constituted by the p-channel MOS transistor Q4 and the n-channel MOS transistor Q6. In this case, the p-channel MOS transistors Q1 and Q4 are used as load transistors and the n-channel MOS transistors Q8′ and Q8 are used as driver transistors. n-channel MOS transistors Q7′ and Q5 are used as access transistors of the memory cell. The n-channel MOS transistor Q7′ corresponds to the n-channel MOS transistor Q7 of the MOS transistors making up the basic cell adjacent to the basic cell comprising the p-channel MOS transistors Q1 to Q4 and the n-channel MOS transistors Q5 to Q8. The memory cell further comprises a word line W and bit lines B1 and B2.

In this embodiment, the wiring is executed by using three layers of aluminium (Al) wiring. In Figure 2, the symbol X denotes a contact portion between the Al wiring of a first of the three layers and the p⁺-type or n⁺-type semiconductor region or gate electrode, the symbol O indicates a contact portion between the Al wiring of a second of the three layers and the Al wiring of the first layer, and the symbol ▭ represents a contact portion between the Al wiring of the third layer and the Al wiring of the second layer. In Figure 2, portions of the Al wiring of the first, second and third layers passing through the contact portions are shown by solid lines ( 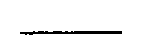 ), broken (dashed) lines (------), and alternate long and short dashed (chain-dotted) lines ( -·-·-·-·- ), respectively. In this case, wiring to supply the power source voltages VDD and VSS is constituted by the Al wiring of the first layer. A portion of the Al wiring of the first layer for supplying the power source voltage VDD comes into contact with the semiconductor regions 2, 5 and 13. A portion of the Al wiring of the first layer for supplying the power source voltage VSS comes into contact with the semiconductor regions 9, 12 and 14. Further, the Al wiring of the first layer for supplying the power source voltage VSS to the basic cell adjacent to the basic cell comprising the p-channel MOS transistors Q1 to Q4 and the n-channel MOS transistors Q5 to Q8 comes into contact with semiconductor regions 12′ and 14′. The word line W is constituted by the Al wiring of the second layer. The bit lines B1 and B2 are constituted by the Al wiring of the third layer. The bit line B1 constituted by the Al wiring of the third layer comes into contact with a semiconductor region 10′ through the Al wiring of the second layer and the Al wiring of the first layer. Similarly, the bit line B2 constituted by the Al wiring of the third layer comes into contact with the semiconductor region 7 through the Al wiring of the second layer and the Al wiring of the first layer.

As mentioned above, according to this embodiment, the full CMOS type static RAM is constituted by the CMOS gate array comprising basic cells as described with reference to Figure 4. Therefore, a memory cell of the full CMOS type static RAM can substantially be constituted by one basic cell as shown in Figure 4 (though the memory cell extends over two adjacent basic cells). In this case, although two p-channel MOS transistors in the basic cell remain unused, those unused p-channel MOS transistors merely occupy about 1/4 of the basic cell. Therefore, the efficiency of usage of the basic cells is higher than in the case of a memory cell of the full CMOS type static RAM constructed from the basic cells as described with reference to Figure 1. Thus, a full CMOS type static RAM in which the integration density of the memory cells is higher than in the case of the previously proposed arrangement can easily be realised from the CMOS gate array.

In the above-described embodiment, the wiring was performed by using three layers of Al wiring. However, for example, if the channel width of each of the p-channel MOS transistors Q1 to Q4 and the n-channel MOS transistors Q5 to Q8 is increased by 1G, the bit lines B1 and B2 can be formed by the Al wiring of the first layer, whereby the Al wiring of the third layer becomes unnecessary. That is, the wiring can be executed by two layers of Al wiring.

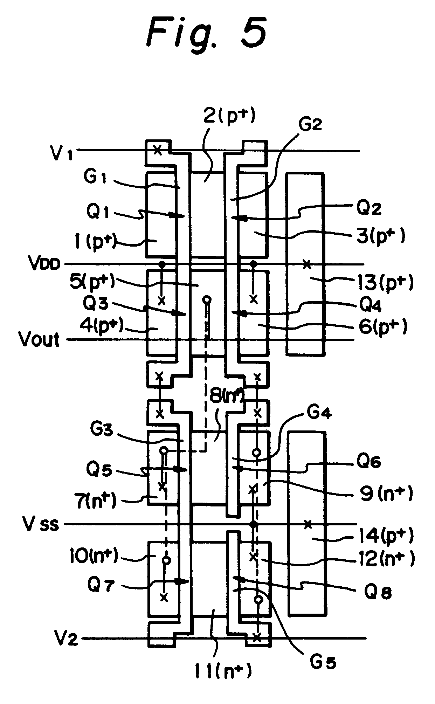

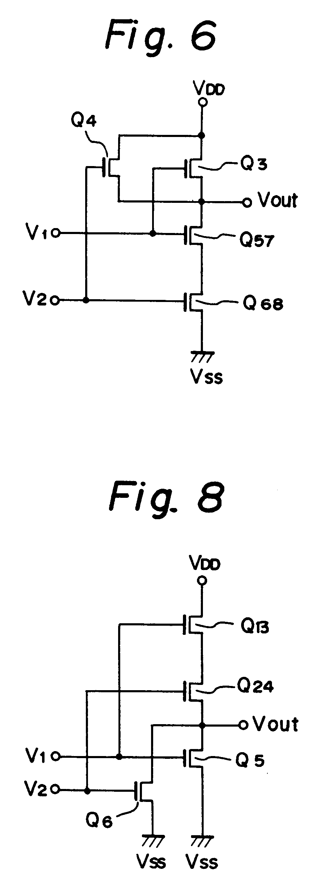

An embodiment in which the CMOS gate array embodying the invention is applied to the construction of a 2-input NAND circuit will now be described with reference to Figures 5 and 6, in which Figure 5 shows the NAND circuit, which is constructed from the sea of gate type CMOS gate array comprising basic cells as described with reference to Figure 4, and Figure 6 shows an equivalent circuit of the NAND circuit shown in Figure 5.

As shown in Figures 5 and 6, the 2-input NAND circuit is formed in this embodiment from the two p-channel MOS transistors Q3 and Q4 and the four n-channel MOS transistors Q5 to Q8 of the basic cell described with reference to Figure 4. The n-channel MOS transistors Q5 and Q7 are connected in parallel with one another and the n-channel MOS transistors Q6 and Q8 are also connected in parallel with one another. In Figure 6, Q57 denotes the parallel-connected n-channel MOS transistors Q5 and Q7 and Q68 denotes the parallel-connected n-channel MOS transistors Q6 and Q8. In this embodiment, the transistors other than the p-channel MOS transistors Q3 and Q4 and the n-channel MOS transistors Q5 and Q8 mentioned above, that is the p-channel MOS transistors Q1 and Q2, are not used.

In Figures 5 and 6, V1 and V2 denote input voltages to gates of the n-channel MOS transistors Q57 and Q68 and Vout indicates an output voltage.

In this embodiment, the wiring is performed by two layers of Al wiring. Wiring for the voltages V1, V2 and Vout is constituted by the Al wiring of the first layer in a manner similar to the wiring for supplying the power source voltages VDD and VSS. In this case, portions of the Al wiring of the first layer for V1 and V2 come into contact with the gate electrodes G1 and G5, respectively; and the Al wiring of the first layer for Vout comes into contact with the semiconductor region 5 and also comes into contact with the semiconductor region 7 through the Al wiring of the first and second layers.

According to this embodiment, since the 2-input NAND circuit is constructed from the basic cell described with reference to Figure 4, the degree of freedom of wiring between the transistors is greater than that in the case of constructing a 2-input NAND circuit using the previously proposed basic cell as described with reference to Figure 1. Therefore, in a case in which, for example, it is assumed that the integration densities are the same, a 2-input NAND circuit having a circuit construction which is closer to an optimum construction than the previously proposed one can easily be realised. Further, since each of the n-channel MOS transistors Q57 and Q68 has a channel width which is twice as large as the channel width of each of the n-channel MOS transistors Q5 to Q8, its current driving capability is very large. Therefore, a 2-input NAND circuit of high performance can be realised.

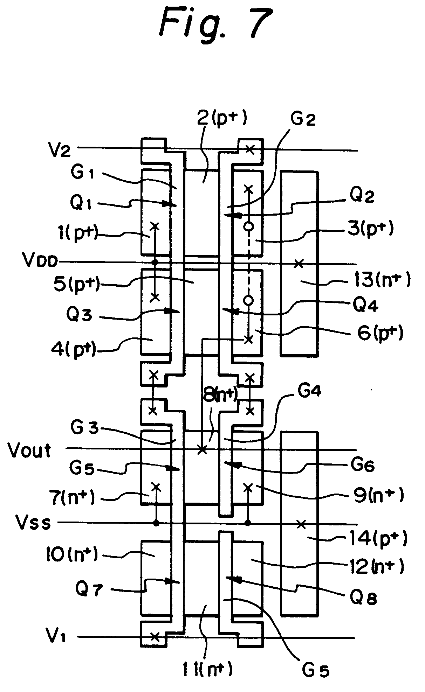

An embodiment in which the CMOS gate array embodying the invention is applied to the construction of a 2-input NOR circuit will now be described with reference to Figures 7 and 8, in which Figure 7 shows the NOR circuit, which is constructed from the sea of gate type CMOS gate array comprising basic cells as described with reference to Figure 4, and Figure 8 shows an equivalent circuit of the NOR circuit shown in Figure 7.

As shown in Figures 7 and 8, the 2-input NOR circuit is formed in this embodiment from the four p-channel MOS transistors Q1 to Q4 and the two n-channel MOS transistors Q5 and Q6 of the basic cell described with reference to Figure 4. The p-channel MOS transistors Q1 and Q3 are connected in parallel with one another and the p-channel MOS transistors Q2 and Q4 are also connected in parallel with one another. In Figure 8, Q13 denotes the parallel-connected p-channel MOS transistors Q1 and Q3 and Q24 denotes the parallel-connected n-channel MOS transistors Q2 and Q4. In this embodiment, the transistors other than the p-channel MOS transistors Q1 to Q4 and the n-channel MOS transistors Q5 and Q6, that is the n-channel MOS transistors Q7 and Q8, are not used.

In this embodiment, the wiring is performed by two layers of Al wiring. Wiring for input voltages V1, V2 to gates of the transistors and wiring for an output voltage Vout is constituted by the Al wiring of the first layer in a manner similar to the wiring for supplying the power source voltages VDD and VSS. In this case, portions of the Al wiring of the first layer for V1 and V2 come into contact with the gate electrodes G3 and G2, respectively; and the Al wiring of the first layer for Vout comes into contact with the semiconductor regions 8 and 6 and also comes into contact with the semiconductor region 3 through the Al wiring of the second and first layers.

According to this embodiment, since the 2-input NOR circuit is constructed from the basic cell described with reference to Figure 4, the degree of freedom of wiring between the transistors is greater than that in the case of constructing a 2-input NOR circuit using the previously proposed basic cell as described with reference to Figure 1. Therefore, a 2-input NOR circuit having a circuit construction which is closer to an optimum construction than the previously proposed one can easily be realised. Further, since each of the p-channel MOS transistors Q13 and Q24 has a channel width which is twice as large as the channel width of each of the p-channel MOS transistors Q1 to Q4, its current driving capability is almost equal to that of the n-channel MOS transistors Q5 to Q8. Therefore, a 2-input NOR circuit of high performance can be realised.

The arrangements in accordance with the invention described above by way of example can be modified within the scope of the invention.

For instance, the dimensions A and 8 of the basic cell shown in Figure 4 and the channel width in and channel length L of each of the p-channel MOS transistors Q1 to Q4 and n-channel MOS transistors Q5 to Q8 constituting the basic cell can be selected in accordance with necessity. Also, the gate electrodes G1 to G5 can have shapes different from those of the above-described embodiments. Further, the method of wiring between the p-channel MOS transistors Q1 to Q4 and n-channel MOS transistors Q5 to Q8 is not limited to the methods used in the above described embodiments.

As well as the applications described above, the invention can be applied to the construction of an inverter circuit, a transmission circuit, or the like.

According to the above-described embodiments, in the case of constructing, for instance, a full CMOS type static RAM, a high integration density of the memory cells can be realised; and in the case of constructing a NAND circuit, a NOR circuit of the like, a circuit construction near or approaching an optimum construction can be realised.

## Claims

1. A semiconductor device of the master slice type, the device having a basic cell comprising:
first and second MOS transistors (Q1,Q2) of a first conductivity type, between which one (2) of a source region and a drain region is commonly used;
third and fourth MOS transistors (Q3,Q4) of the first conductivity type, between which one (5) of a source region and a drain region is commonly used;
fifth and sixth MOS transistors (Q5,Q6) of a second conductivity type, between which one (8) of a source region and a drain region is commonly used; and
seventh and eighth MOS transistors (Q7,Q8) of the second conductivity type, between which one (11) of a source region and a drain region is commonly used;
a gate electrode (G1) being commonly used between the first and third MOS transistors (Q1,Q3), a gate electrode (G2) being commonly used between the second and fourth MOS transistors (Q2,Q4), a gate electrode (G3) being commonly used between the fifth and seventh MOS transistors (Q5,Q7) and gate electrodes (G4,G5) of the sixth and eighth MOS transistors (Q6,Q8) being separately used from each other.

2. A semiconductor device according to claim 1 or claim 2, wherein the first to fourth MOS transistors (Q1 to Q4) are p-channel MOS transistors and the fifth to eighth MOS transistors (Q5 to Q8) are n-channel MOS transistors.

3. A semiconductor device according to claim 1, claim 2 or claim 3, wherein channel width to channel length ratios (W/L) of the first to fourth MOS transistors (Q1 to Q4) are equal and channel width to channel length ratios (W/L) of the fifth to eighth MOS transistors (Q5 to Q8) are equal.

4. A semiconductor device according to any one of claims 1 to 3, wherein a memory cell of a full CMOS static RAM is constructed using one said basic cell.

5. A semiconductor device according to any one of claims 1 to 3, wherein a NAND circuit is constructed using one said basic cell.

6. A semiconductor device according to any one of claims 1 to 3, wherein a NOR circuit is constructed using one said basic cell.

## Revendications

1. Dispositif semi-conducteur de type à plaquette à circuit intégré, le dispositif ayant une cellule de base comprenant :
des premier et second transistors MOS (Q1, Q2) d'un premier type de conductivité, entre lesquels une zone (2) d'une zone source et d'une zone de drain est généralement utilisée ;
des troisième et quatrième transistors MOS (Q3, Q4) du premier type de conductivité, entre lesquels une zone(5) d'une zone source et d'une zone de drain est généralement utilisée ;
des cinquième et sixième transistors MOS (Q5, Q6) d'un second type de conductivité entre lesquels une zone (8) d'une zone source et d'une zone de drain est généralement utilisée ; et
des septième et huitième transistors MOS (Q7, Q8) du second type de conductivité, entre lesquels une zone (11) d'une zone source et d'une zone de drain est généralement utilisée ;
une électrode de grille (G1) étant généralement utilisée entre les premier et troisième transistors MOS (Q1, Q3), une électrode de grille (G2) étant généralement utilisée entre les second et quatrième transistors MOS (Q2, Q4), une électrode de grille (G3) étant généralement utilisée entre les cinquième et septième transistors MOS (Q5, Q7) et des électrodes de grille (G4, G5) des sixième et huitième transistors MOS (Q 6, Q8) étant utilisées séparément les unes des autres.

2. Dispositif semi-conducteur selon la revendication 1 ou la revendication 2, dans lequel les premier au quatrième transistors MOS (Q1 à Q4) sont des transistors MOS à canal p et les cinquième au huitième transistors MOS (Q5 à Q8) sont des transistors MOS à canal n.

3. Dispositif semi-conducteur selon la revendication 1, la revendication 2 ou la revendication 3, dans lequel des rapports largeur de canal sur longueur de canal (W/L) des premier au quatrième transistors MOS (Q1 à Q4) sont égaux et des rapports de largeur de canal sur longueur de canal (W/L) des cinquième au huitième transistors MOS (Q5 à Q8) sont égaux.

4. Dispositif semi-conducteur selon l'une quelconque des revendications 1 à 3, dans lequel une cellule mémoire d'une mémoire RAM statique de type entièrement en CMOS est construite en utilisant ladite cellule de base.

5. Dispositif semi-conducteur selon l'une quelconque des revendications 1 à 3, dans lequel un circuit ET inversé est construit en utilisant ladite cellule de base.

6. Dispositif semi-conducteur selon l'une quelconque des revendications 1 à 3, dans lequel un circuit OU inversé est construit en utilisant ladite cellule de base.

## Patentansprüche

1. Masterslice-Halbleiterbauelement mit einer Basiszelle, die
erste und zweite MOS-Transistoren (Q1,Q2) eines ersten Leitfähigkeitstyps, bei denen entweder ein Source-Gebiet oder ein Drain-Gebiet ein von beiden gemeinsam genutztes Gebiet (2) bildet,
dritte und vierte MOS-Transistoren (Q3,Q4) des ersten Leitfähigkeitstyps, bei denen entweder ein Source-Gebiet oder ein Drain-Gebiet ein von beiden gemeinsam genutztes Gebiet (5) bildet,
fünfte und sechste MOS-Transistoren (Q5,Q6) eines zweiten Leitfähigkeitstyps, bei denen entweder ein Source-Gebiet oder ein Drain-Gebiet ein von beiden gemeinsam genutztes Gebiet (8) bildet, und
siebte und achte MOS-Transistoren (Q7,Q8) des zweiten Leitfähigkeitstyps, bei denen entweder ein Source-Gebiet oder ein Drain-Gebiet ein von beiden gemeinsam genutztes Gebiet (11) bildet, umfaßt,
sowie eine von den ersten und dritten MOS-Transistoren (Q1,Q3) gemeinsam genutzte Gate-Elektrode (G1), eine von den zweiten und vierten MOS-Transistoren (Q2,Q4) gemeinsam genutzte Gate-Elektrode (G2), eine von den fünften und siebten MOS-Transistoren (Q5,Q7) gemeinsam genutzte Gate-Elektrode (G3), und von den sechsten und achten MOS-Transistoren (Q6,Q8) getrennt voneinander genutzte Gate-Elektroden (G4,G5).

2. Halbleiterbauelement nach Anspruch 1, wobei die ersten bis vierten MOS-Transistoren (Q1 bis Q4) p-Kanal-MOS-Transistoren und die fünften bis achten MOS-Transistoren (Q5 bis Q8) n-Kanal-MOS-Transistoren sind.

3. Halbleiterbauelement nach Anspruch 1 oder Anspruch 2, wobei die ersten bis vierten MOS-Transistoren (Q1 bis Q4) jeweils dasselbe Verhältnis von Kanalbreite zu Kanallänge (W/L) haben und die fünften bis achten MOS-Transistoren (Q5 bis Q8) jeweils dasselbe Verhältnis von Kanalbreite zu Kanallänge (W/L) haben.

4. Halbleiterbauelement nach irgendeinem der Ansprüche 1 bis 3, wobei eine Speicherzelle eines statischen CMOS-RAM unter Verwendung einer Basiszelle konstruiert ist.

5. Halbleiterbauelement nach irgendeinem der Ansprüche 1 bis 3, wobei eine NAND-Schaltung unter Verwendung einer Basiszelle konstruiert ist.

6. Halbleiterbauelement nach irgendeinem der Ansprüche 1 bis 3, wobei eine NOR-Schaltung unter Verwendung einer Basiszelle konstruiert ist.
